(19) **Europäisches Patentamt / European Patent Office / Office européen des brevets**

(11) **EP 4 704 301 A1**

(12) **EUROPEAN PATENT APPLICATION**

(43) Date of publication:
**04.03.2026 Bulletin 2026/10**

(21) Application number: **25182986.7**

(22) Date of filing: **16.06.2025**

(51) International Patent Classification (IPC):
$H02J\ 13/00^{(2026.01)}$     $H02J\ 3/00^{(2026.01)}$
$H02G\ 7/16^{(2006.01)}$     $H02G\ 1/02^{(2006.01)}$
$H02G\ 7/00^{(2006.01)}$

(52) Cooperative Patent Classification (CPC):
**H02J 13/12; H02G 1/02; H02G 7/00; H02G 7/16; H02J 3/0012**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **28.08.2024 CN 202411193155**

(71) Applicants:
- **Southern Power Grid Sensing Technology (Guangdong) Co., Ltd**
  **Shenzhen, Guangdong 518102 (CN)**
- **CSG Digital Power Grid Research Institute Co., Ltd.**
  **Guangzhou, Guangdong 510700 (CN)**

(72) Inventors:
- **LIU, Yuquan**
  **518102 Shenzhen, Guangdong (CN)**
- **ZHAO, Jiguang**
  **518102 Shenzhen, Guangdong (CN)**
- **WANG, Zhiming**
  **518102 Shenzhen, Guangdong (CN)**
- **ZHANG, Fuchun**
  **518102 Shenzhen, Guangdong (CN)**
- **TIAN, Bing**
  **518102 Shenzhen, Guangdong (CN)**
- **XU, Zhenheng**
  **518102 Shenzhen, Guangdong (CN)**
- **FAN, Lingmeng**
  **518102 Shenzhen, Guangdong (CN)**
- **HUANG, Chuwei**
  **518102 Shenzhen, Guangdong (CN)**
- **GUO, Tao**
  **518102 Shenzhen, Guangdong (CN)**
- **LI, Yanfei**
  **518102 Shenzhen, Guangdong (CN)**
- **ZHANG, Weixun**
  **518102 Shenzhen, Guangdong (CN)**
- **ZHANG, Keyi**
  **518102 Shenzhen, Guangdong (CN)**
- **ZHAO, Liang**
  **518102 Shenzhen, Guangdong (CN)**
- **XU, Wenping**
  **518102 Shenzhen, Guangdong (CN)**
- **WEI, Yupeng**
  **518102 Shenzhen, Guangdong (CN)**
- **XIE, Chun**
  **518102 Shenzhen, Guangdong (CN)**
- **MO, Zhengkun**
  **518102 Shenzhen, Guangdong (CN)**
- **ZHANG, Na**
  **518102 Shenzhen, Guangdong (CN)**
- **YIN, Xu**
  **518102 Shenzhen, Guangdong (CN)**
- **ZHANG, Jiaming**
  **518102 Shenzhen, Guangdong (CN)**

(74) Representative: **Hoffmann Eitle**
**Patent- und Rechtsanwälte PartmbB**
**Arabellastraße 30**
**81925 München (DE)**

(54) **METHOD AND APPARATUS FOR POWER TRANSMISSION LINE ICING WARNING**

(57) A method for power transmission line icing warning is provided, including obtaining a current line temperature and a current maximum sag of a target power transmission line, determining a predicted maximum sag of the target power transmission line at the current line temperature based on the current line temperature and a maximum sag-line temperature correspondence, determining whether there is ice on the target power transmission line based on the current maximum sag and the predicted maximum sag, and issuing an icing warning for the target power transmission line when it is determined that there is ice on the target power transmission line.

Information processing device 101 — Monitoring device 102

FIG. 1

EP 4 704 301 A1

**Description**

CROSS-REFERENCE TO RELATED APPLICATIONS

The present application claims priority to Chinese patent application No. 202411193155.1, filed on August 28, 2024, the entire content of which is incorporated herein by reference.

TECHNICAL FIELD

The present application relates to the technical field of power transmission lines, particularly to a method and apparatus for power transmission line icing warning.

BACKGROUND

With the rapid development of the power industry, the safety of power transmission lines has received extensive attention. Power transmission lines are prone to icing in winter, which can easily lead to accidents such as ice flashover tripping, tower collapse, and wire breakage of power transmission lines, seriously affecting the safe and stable operation of the power grid. Therefore, predicting and warning in advance the impact scope and degree of icing on power transmission lines can effectively prevent icing-related disasters of power transmission lines and greatly support the safe and stable operation of power transmission lines.

At present, most of the icing warning methods for power transmission lines in the existing technologies are icing prediction methods for power transmission lines based on multi-physical quantity mathematical models. However, the parameter acquisition of the models in the existing technologies is not accurate enough, and human experience factors play a dominant role. Therefore, these methods do not have strong theoretical rationality, resulting in a relatively low accuracy of the prediction results of icing disasters on power transmission lines.

Researchers have conducted extensive studies in the field of ice accretion monitoring. Traditional monitoring methods include establishing ice observation stations, manual inspections, and installing simulation wires. These methods are inefficient, error-prone, and unable to provide real-time feedback on the localized ice accretion status of micro-topography and small climate power grids. Image-based methods are simple and intuitive with strong timeliness, but the clarity of the images cannot be effectively guaranteed under complex meteorological conditions. The weighing method (tension sensor method) uses angle and tension sensors to monitor the tilt angle and load of insulators, combining meteorological conditions to calculate changes in conductor tension using equivalent ice thickness models, with errors smaller than 0.05mm, offering higher precision. However, the reliability and service life of sensors in low-temperature, high-humidity conditions are difficult to ensure. Statistics show that the failure rate of current ice accretion monitoring devices exceeds 30%, with high and challenging costs for power outages and repairs each year. In addition, this method requires regular calibration, complex installation, and may impact the existing structure of the power lines.

SUMMARY

In a first aspect, the present application provides a method for power transmission line icing warning, including: obtaining a current line temperature and a current maximum sag of a target power transmission line; determining a predicted maximum sag of the target power transmission line at the current line temperature based on the current line temperature and a maximum sag-line temperature correspondence; determining whether there is ice on the target power transmission line based on the current maximum sag and the predicted maximum sag; and issuing an icing warning for the target power transmission line when it is determined that there is ice on the target power transmission line.

In some embodiments, the maximum sag-line temperature correspondence is determined by: obtaining historical monitoring data of the target power transmission line through a monitoring device installed on the target power transmission line, the historical monitoring data including historical line temperatures and historical maximum sags at different historical times; selecting, from the historical monitoring data, historical monitoring data of the target power transmission line in an ideal environment as target monitoring data, the ideal environment including at least an ice-free and wind-free environment; and constructing the maximum sag-line temperature correspondence for the target power transmission line based on the target monitoring data.

In some embodiments, determining whether there is ice on the target power transmission line based on the current maximum sag and the predicted maximum sag includes: taking a difference between the current maximum sag and the predicted maximum sag as a sag difference; and if the sag difference is greater than a preset error threshold, determining that there is ice on the target power transmission line.

In some embodiments, issuing the icing warning for the target power transmission line includes: obtaining characteristic data and a current specific load parameter of the target power transmission line; determining an icing thickness of the target power transmission line based on the characteristic data and the current specific load parameter; and issuing the icing warning for the target power transmission line based on the icing thickness.

In some embodiments, the characteristic data includes static characteristic data and dynamic characteristic data, and obtaining the characteristic data and the current specific load parameter of the target power transmission line includes: obtaining the dynamic characteristic data through a monitoring device installed on the target power transmission line; determining the static characteristic data based on attribute information of the target power transmission line; and determining the current specific load parameter of the target power transmission line based on the static characteristic data, the dynamic characteristic data, the predicted maximum sag and the current maximum sag.

In some embodiments, the static characteristic data includes an outer diameter, a cross-sectional area, a mass parameter, a temperature expansion coefficient and an elasticity coefficient of the target power transmission line, the dynamic characteristic data includes a horizontal span, a height difference angle, a wind deflection angle, a first temperature in an ideal environment and a second temperature in an abnormal environment of the target power transmission line, and the current specific load parameter includes a self-weight specific load in the ideal environment and a comprehensive specific load in the abnormal environment. The ideal environment includes at least an ice-free and wind-free environment, and the abnormal environment includes at least an environment with ice and/or wind.

In some embodiments, determining the current specific load parameter of the target power transmission line based on the static characteristic data, the dynamic characteristic data, the predicted maximum sag and the current maximum sag includes: taking a product of the mass parameter and a gravitational acceleration as a first intermediate parameter; determining the self-weight specific load based on a ratio between the first intermediate parameter and the cross-sectional area; and determining the comprehensive specific load based on the self-weight specific load, the predicted maximum sag, the current maximum sag, the static characteristic data and the dynamic characteristic data.

In some embodiments, determining the comprehensive specific load based on the self-weight specific load, the predicted maximum sag, the current maximum sag, the static characteristic data and the dynamic characteristic data includes: taking a ratio of a product of the current maximum sag and the self-weight specific load to the predicted maximum sag as a second intermediate parameter; determining a third intermediate parameter based on the current maximum sag, the predicted maximum sag, the elasticity coefficient, the horizontal span and the height difference angle; determining a fourth intermediate parameter based on the temperature expansion coefficient, the current maximum sag, the first temperature, the second temperature, the height difference angle and the horizontal span; and taking a difference between the difference between the second intermediate parameter and the third intermediate parameter and the fourth intermediate parameter as the comprehensive specific load.

In some embodiments, determining the icing thickness of the target power transmission line based on the characteristic data and the current specific load parameter, includes: taking a difference between a product of a cosine value of the wind deflection angle and the comprehensive specific load and the self-weight specific load as a fifth intermediate parameter; and determining the icing thickness of the target power transmission line based on the cross-sectional area, the outer diameter and the fifth intermediate parameter.

In some embodiments, issuing the icing warning for the target power transmission line when it is determined that there is ice on the target power transmission line includes issuing the icing warning for the target power transmission line to a control center corresponding to the target power transmission line. The icing warning contains an on-site image of the target power transmission line.

In some embodiments, the maximum sag-line temperature correspondence includes a correspondence between the maximum sag, the line temperature and a humidity. Determining the predicted maximum sag of the target power transmission line at the current line temperature includes determining the predicted maximum sag of the target power transmission line at the current line temperature based on the current line temperature, a current humidity, and the correspondence between the maximum sag, the line temperature and the humidity.

In some embodiments, the method further includes acquiring an on-site image of the target power transmission line, and determining whether there is ice on the target power transmission line using an image recognition algorithm.

In a second aspect, the present application provides an apparatus for power transmission line icing warning, including: a data obtaining module, configured to obtain a current line temperature and a current maximum sag of a target power transmission line; a sag determination module, configured to determine a predicted maximum sag of the target power transmission line at the current line temperature based on the current line temperature and a maximum sag-line temperature correspondence; an icing determination module, configured to determine whether there is ice on the target power transmission line based on the current maximum sag and the predicted maximum sag; and an icing warning module, configured to issue an icing warning for the target power transmission line when it is determined that there is ice on the target power transmission line.

In a third aspect, the present application provides a computer device, which includes a memory and a processor. The memory stores a computer program therein. The processor, when executing the computer program, is configured to perform a method for power transmission line icing warning according to any one of the above embodiments.

In a fourth aspect, the present application provides a computer-readable storage medium storing a computer program therein. The computer program, when executed by a processor, causes the processor to perform a method for power transmission line icing warning according to any one of the above embodiments.

In a fifth aspect, the present application also provides a computer program product including a computer program. The computer program, when executed by a processor, causes the processor to perform a method for power transmission line icing warning according to any one of the above embodiments.

According to the above-mentioned method and apparatus for power transmission line icing warning, the current line temperature and the current maximum sag of the target power transmission line are obtained. Then, based on the current line temperature and the maximum sag-line temperature correspondence, the predicted maximum sag of the target power transmission line at the current line temperature is determined. Subsequently, based on the current maximum sag and the predicted maximum sag, it is determined whether there is ice on the target power transmission line. If it is determined that there is ice on the target power transmission line, an icing warning for the target power transmission line is issued. In this solution, by introducing the maximum sag-line temperature correspondence, the maximum sags of the target power transmission line under different line temperatures can be accurately reflected. Thus, based on the correspondence, the predicted maximum sag of the target power transmission line at the current line temperature, i.e., the maximum sag when no icing occurs, can be accurately determined. Further, based on the current maximum sag and the predicted maximum sag, it can be rationally and accurately determined whether there is ice on the target power transmission line, enabling an accurate icing warning for the target power transmission line.

## BRIEF DESCRIPTION OF THE DRAWINGS

To more clearly illustrate the technical solutions in the embodiments of the present application or in related technologies, the following briefly introduces the drawings required for the description of the embodiments or related technologies. Obviously, the drawings in the following description are only some embodiments of the present application. For those of ordinary skill in the art, other drawings can be obtained based on these drawings without creative efforts.

FIG. 1 is an application environment diagram of a method for power transmission line icing warning in an embodiment.
FIG. 2 is a flowchart of a method for power transmission line icing warning in an embodiment.
FIG. 3 is a flowchart of determining a maximum sag-line temperature correspondence in an embodiment.
FIG. 4 shows a constructed curve of the maximum sag of a target power transmission line changing with a line temperature in an embodiment.
FIG. 5 is a flowchart of determining whether there is ice on a target power transmission line in an embodiment.
FIG. 6 is a flowchart of issuing an icing warning for a target power transmission line in an embodiment.
FIG. 7 is a flowchart of obtaining characteristic data and a current specific load parameter in an embodiment.
FIG. 8 is a flowchart of determining a current specific load parameter of a target power transmission line in an embodiment.
FIG. 9 is a flowchart of determining a comprehensive specific load of a target power transmission line in an embodiment.
FIG. 10 is a flowchart of determining an icing thickness of a target power transmission line in an embodiment.
FIG. 11 is a flowchart of a method for power transmission line icing warning in another embodiment.
FIG. 12 is a structural block diagram of an apparatus for power transmission line icing warning in an embodiment.
FIG. 13 is an internal structural diagram of a computer device in an embodiment.

## DETAILED DESCRIPTION

In order to make the objectives, technical solutions, and advantages of the present application more clearly understood, the following provides a more detailed description of the present application in conjunction with the accompanying drawings and embodiments. It should be understood that the specific embodiments described herein are only used to explain the present application, and are not intended to limit the present application.

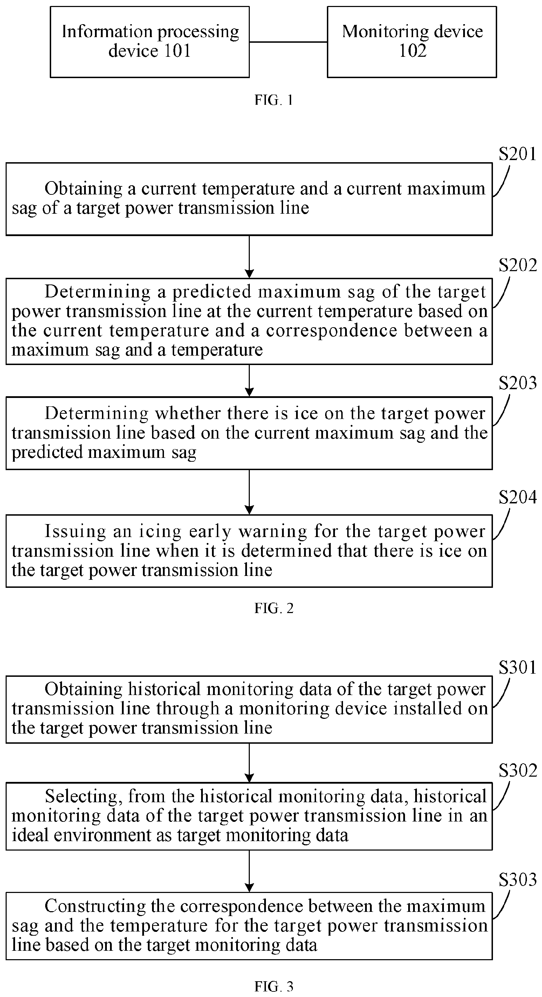

The method for power transmission line icing warning provided in the embodiments of the present application can be applied to the application environment shown in FIG. 1. The monitoring device 102 is installed on a target power transmission line and is configured to monitor the target power transmission line and the environment where the target power transmission line is located. The information processing device 101 is configured to process the monitoring data obtained by the monitoring device. Optionally, after obtaining a current line temperature and a current maximum sag of the target power transmission line monitored by the monitoring device 102, the information processing device 101 determines a predicted maximum sag of the target power transmission line at the current line temperature based on a maximum sag-line temperature correspondence, and then determines whether there is ice on the target power transmission line based on the current maximum sag and the predicted maximum sag. When it is determined that there is ice on the target power transmission line, an icing warning for the target power transmission line is issued.

In an embodiment, as shown in FIG. 2, a method for power transmission line icing warning is provided. Taking the method performed by the information processing device 101 in FIG. 1 as an example for illustration, the method specifically includes the following steps S201-S204.

In the step S201, a current line temperature and a current maximum sag of the target power transmission line are obtained.

The target power transmission line is the power transmission line whose icing situation needs to be monitored. Further, the target power transmission line can be the power transmission line between any two adjacent poles within the monitoring range. The current line temperature refers to the temperature of, for example, a conductor of the target power transmission line in the current time period. The sag is the vertical distance between the lowest point of the target power transmission line and a connecting line between two suspension points at which the target power transmission line is connected to the poles. Generally, the suspension points of the target power transmission line on two adjacent poles are at the same height. The current maximum sag is, for example, the maximum sag of the target power transmission line under a specified horizontal span in the current time period.

Optionally, in the embodiments of the present application, the situation of the target power transmission line and the environment where the target power transmission line is located can be monitored in real-time through the monitoring device installed on the target power transmission line. Therefore, the current line temperature and the current maximum sag of the target power transmission line at the current moment can be obtained through the monitoring device. Exemplarily, the monitoring device can be a device integrating various sensors, such as infrared sensors, ultraviolet sensors, sonar sensors, meteorological sensors, sag monitoring sensors, temperature sensors, etc.

It can be understood that through the monitoring device, not only the current line temperature and the current maximum sag of the target power transmission line can be obtained, but also information such as the line temperature, the humidity, and the air pressure of the environment where the target power transmission line is located can be obtained.

In an embodiments, the current line temperature of the transmission line can be obtained by fusing the measurement data from two temperature measurement methods: platinum resistors or thermistors (non-contact) and infrared thermopiles (non-contact). Long-term measured data are used to train a temperature data fusion model for cleaning the measurement data. For contact temperature measurement, temperature sensor probes are deployed at multiple points inside the potential rubber (used for contact and fixation between the sensor and the conductor, which avoids abrasion of the conductor and achieves reliable equipotential). For direct contact measurement of the transmission line, the outermost shell of the temperature sensor probe is made of aluminum or galvanized aluminum, etc., to provide corrosion resistance and durability in harsh environments.

In an embodiment, the maximum sag of the transmission line is determined based on inclination angles of the transmission line. The inclination angle is the angle between the transmission line at the suspension point and the horizontal line, which can be obtained through an inclination sensor.

Based on the inclination angle, a catenary equation of the transmission line can be obtained. From the catenary equation, the sag at various points on the transmission line can be determined, allowing the maximum sag to be obtained.

In another embodiment, the maximum sag is achieved using positioning sensors. For example, the fusion positioning technology of BeiDou RTK (Real Time Kinematic) and GPS RTK is used. In terms of hardware, a fusion solution combining a single BeiDou RTK chip and a GPS RTK positioning chip is adopted. On the data side, a positioning data fusion model trained with long-term measurement data is used for data cleaning and processing, thereby achieving accurate positioning with an accuracy of up to 10mm for fixed-point sensors.

In the step S202, a predicted maximum sag of the target power transmission line at the current line temperature is determined based on the current line temperature and a correspondence between a maximum sag and a temperature.

The maximum sag-line temperature correspondence represents the maximum sags of the target power transmission line at different line temperatures, especially the maximum sags of the target power transmission line at different line temperatures in an ideal environment. The ideal environment includes at least an ice-free and wind-free environment. In the embodiments of the present application, the maximum sag-line temperature correspondence can be represented by a curve.

Optionally, a maximum sag corresponding to the current line temperature can be determined based on the maximum sag-line temperature correspondence, and the determined maximum sag is taken as the predicted maximum sag of the target power transmission line at the current line temperature.

In the step S203, whether there is ice on the target power transmission line is determined based on the current maximum sag and the predicted maximum sag.

Optionally, the current maximum sag and the predicted maximum sag can be input into an icing prediction model, so that the icing prediction model outputs a prediction result of whether there is ice on the target power transmission line based on preset parameters, and then whether there is ice on the target power transmission line can be determined based on the prediction result.

It should be noted that in order to ensure the accuracy of the prediction result, after obtaining the prediction result, an on-site image of the target power transmission line acquired by the monitoring device can also be used, and an image recognition algorithm is adopted to recognize the on-site image and output a recognition result to determine whether there is ice on the target power transmission line. If the prediction result is different from the recognition result, the icing prediction model needs to be adjusted and optimized to ensure the accuracy of the icing prediction model.

In the step S204, when it is determined that there is ice on the target power transmission line, an icing warning for the target power transmission line is issued.

Optionally, when it is determined that there is ice on the target power transmission line, in order to avoid accidents such as ice-flash tripping, tower collapse, and wire breakage of the power transmission line, it is necessary to issue an icing warning for the target power transmission line in a timely manner. Exemplarily, a warning message containing an on-site image of the target power transmission line can be sent to a control center corresponding to the target power transmission line, and it is informed that there may be ice on the target power transmission line.

According to the above-mentioned method for power transmission line icing warning, the current line temperature and the current maximum sag of the target power transmission line are obtained. Then, based on the current line temperature and the maximum sag-line temperature correspondence, the predicted maximum sag of the target power transmission line at the current line temperature is determined. Subsequently, based on the current maximum sag and the predicted maximum sag, it is determined whether there is ice on the target power transmission line. If it is determined that there is ice on the target power transmission line, an icing warning for the target power transmission line is issued. In this solution, by introducing the maximum sag-line temperature correspondence, the maximum sags of the target power transmission line under different line temperatures can be accurately reflected. Thus, based on the correspondence, the predicted maximum sag of the target power transmission line at the current line temperature, i.e., the maximum sag when no icing occurs, can be accurately determined. Further, based on the current maximum sag and the predicted maximum sag, it can be rationally and accurately determined whether there is ice on the target power transmission line, enabling an accurate icing warning for the target power transmission line.

Optionally, in an embodiment, as shown in FIG. 3, a method for determining the maximum sag-line temperature correspondence is provided, which specifically includes the following steps S301-S303.

In the step S301, historical monitoring data of the target power transmission line is obtained through the monitoring device installed on the target power transmission line.

The historical monitoring data includes historical line temperatures and historical maximum sags at different historical times.

Optionally, the historical line temperatures and the historical maximum sags of the target power transmission line at different historical times monitored within a historical period can be selected from the monitoring device installed on the target power transmission line and used as the historical monitoring data of the target power transmission line.

In the step S302, the historical monitoring data of the target power transmission line in an ideal environment is selected from the historical monitoring data as the target monitoring data.

The ideal environment includes at least an ice-free and wind-free environment.

Optionally, in an ideal environment, i.e., in an ice-free and wind-free environment, the historical line temperatures and historical maximum sags of the target power transmission line at different historical times are more referential. Therefore, it is necessary to select the historical monitoring data of the target power transmission line in an ideal environment from the historical monitoring data. Specifically, combined with the environmental temperature and humidity data and meteorological data at different historical times, the historical monitoring data of the target power transmission line in an ideal environment can be selected from the historical monitoring data as the target monitoring data.

In the step S303, the maximum sag-line temperature correspondence for the target power transmission line is constructed based on the target monitoring data.

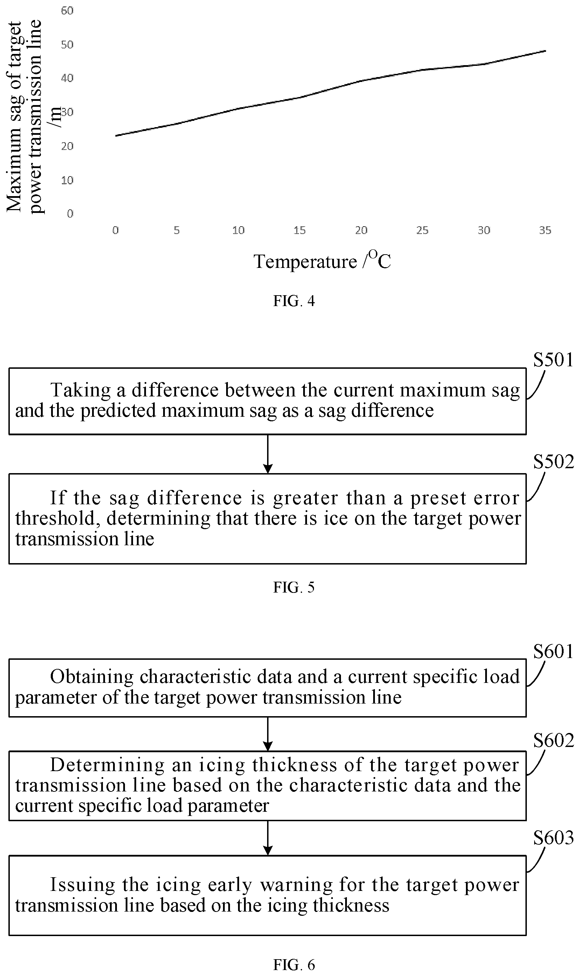

Optionally, there are many methods for constructing the maximum sag-line temperature correspondence for the target power transmission line based on the target monitoring data, which are not limited here. In one of the methods, a fitting method is used to fit a curve of the maximum sag changing with the line temperature based on the historical line temperatures and the historical maximum sags in the target monitoring data to represent the maximum sag-line temperature correspondence. Exemplarily, FIG. 4 shows a constructed curve of the maximum sag of the target power transmission line changing with the line temperature in the embodiments of the present application.

In this embodiment, the accuracy of the obtained historical monitoring data is ensured through the monitoring device. At the same time, the target monitoring data of the target power transmission line in an ideal environment is selected, which ensures the availability and referential value of the target monitoring data, and further ensures the accuracy and referential value of the constructed correspondence between the maximum sag and line temperature.

In some embodiments, the historical monitoring data also includes historical line temperatures, historical humidity and historical maximum sags at different historical times, and the maximum sag-line temperature correspondence includes a correspondence between the maximum sag and line temperature and humidity. Historical monitoring data of the target transmission line under ideal environmental conditions is extracted from the historical monitoring data as target monitoring data. According to the target monitoring data, the correspondence between the maximum sag of the target transmission line and line temperature and humidity is constructed. Based on the correspondence between the maximum sag and line temperature and humidity, as well as the current line temperature, and the current humidity, the maximum sag is determined.

In this embodiment, the maximum sag-line temperature correspondence and humidity can be represented as a table, from which the maximum sag can be obtained by looking up the table. Alternatively, this relationship can be embodied as an AI model, which is trained by learning from historical monitoring data. The maximum sag is derived by inputting the current line temperature and humidity into the model.

Optionally, in an embodiment, as shown in FIG. 5, a method for determining whether there is ice on the target power transmission line is provided, which specifically includes the following steps S501-S502.

In the S501, a difference between the current maximum sag and the predicted maximum sag is taken as a sag difference.

Optionally, the predicted maximum sag can be subtracted from the current maximum sag, and the obtained difference is taken as the sag difference. Specifically, the sag difference can be expressed by the following formula (1):

$$f = f_2 - f_1 \qquad (1)$$

where $f$ is the sag difference, $f_2$ is the current maximum sag, and $f_1$ is the predicted maximum sag.

In the step S502, if the sag difference is greater than a preset error threshold, it is determined that there is ice on the target power transmission line.

The preset error threshold is a threshold set based on an actual situation or experiments.

Optionally, if the sag difference is greater than the preset error threshold, it indicates that there is a possibility of icing on the target power transmission line, and it can be determined that an icing warning is required.

**In** this embodiment, by introducing the sag difference and the preset error threshold, it can be accurately and reasonably determined whether there is ice on the target power transmission line.

Optionally, in an embodiment, as shown in FIG. 6, a method for issuing an icing warning for the target power transmission line is provided, which specifically includes the following steps S601-S 603.

In the step S601, characteristic data and a current specific load parameter of the target power transmission line are obtained.

The characteristic data includes static characteristic data and dynamic characteristic data. The static characteristic data includes an outer diameter, a cross-sectional area, a mass parameter, a temperature expansion coefficient and an elasticity coefficient of the target power transmission line. The dynamic characteristic data includes a horizontal span, a height-difference angle, a wind deflection angle, a first temperature in an ideal environment and a second temperature in an abnormal environment of the target power transmission line. Specific load refers to the load that a unit length and unit cross-section of a conductor can withstand. The current specific load parameter includes a self-weight specific load in the ideal environment and a comprehensive specific load in the abnormal environment. The ideal environment includes at least an ice-free and wind-free environment, and the abnormal environment includes at least an environment with ice and/or wind.

Horizontal span refers to the horizontal distance between two transmission poles, which is the straight-line distance between the two poles. The height-difference angle refers to the angle formed by the height difference of the transmission line between the two poles and the horizontal span. This height-difference angle describes the variation of the transmission line in the vertical direction, which is usually caused by terrain or environmental factors. Wind deflection angle refers to the angle of deviation of the transmission line from its vertical direction due to wind force. The magnitude of the wind deflection angle is closely related to wind speed, wind direction, and the stress conditions of the transmission line.

Optionally, the characteristic data of the target power transmission line can be obtained by referring to relevant parameters of the target power transmission line or through on-site measurement. Meanwhile, the current specific load parameter of the target power transmission line can be obtained by referring to relevant materials and carrying out a reasonable derivation.

In the step S602, an icing thickness of the target power transmission line is determined based on the characteristic data and the current specific load parameter.

The icing thickness refers to the thickness of the ice covering on the target power transmission line.

Optionally, considering the relationship between the characteristic parameters, stress and the current specific load parameter, a reasonable derivation of the icing thickness can be carried out to obtain a relational expression between the icing thickness, the characteristic data and the current specific load parameter. Further, based on the relational expression and combined with the characteristic data and the current specific load parameter, the icing thickness of the target power transmission line can be calculated.

In the step S603, an icing warning for the target power transmission line is issued based on the icing thickness.

Optionally, after calculating the icing thickness, the monitoring device can be controlled to collect an on-site image of the target power transmission line, and a warning message containing the icing thickness and the on-site image can be generated. Further, the warning message is sent to a control center corresponding to the target power transmission line to issue an icing warning for the target power transmission line.

In this embodiment, by comprehensively considering the characteristic data and the current specific load parameter of the target power transmission line to calculate the icing thickness, the rationality and accuracy of the calculated icing thickness are ensured. Further, issuing an icing warning based on the icing thickness ensures the high-efficiency and effectiveness of the warning process.

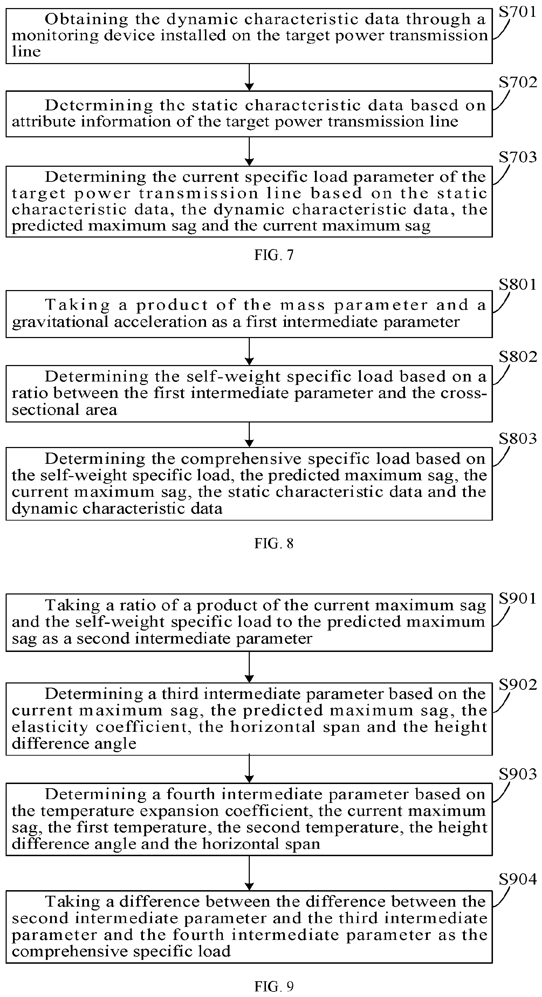

Optionally, the characteristic data includes static characteristic data and dynamic characteristic data. In an embodiment, as shown in FIG. 7, a method for obtaining the characteristic data and the current specific load parameter is provided, which specifically includes the following steps S701-S703.

In the step S701, the dynamic characteristic data is obtained through the monitoring device installed on the target power transmission line.

Optionally, since the dynamic data is changeable and real-time, the dynamic characteristic data can be obtained through the monitoring device installed on the target power transmission line. The dynamic characteristic data includes the horizontal span, the height-difference angle, the wind deflection angle, the first temperature in an ideal environment and the second temperature in an abnormal environment of the target power transmission line.

In the step S702, the static characteristic data is determined based on attribute information of the target power transmission line.

Optionally, since the static characteristic data generally represents the inherent attributes of the target power transmission line, the static characteristic data can be obtained by referring to relevant materials based on the attribute information of the target power transmission line. The static characteristic data includes the outer diameter, the cross-sectional area, the mass parameter, the temperature expansion coefficient and the elasticity coefficient of the target power transmission line.

In the step S703, the current specific load parameter of the target power transmission line is determined based on the static characteristic data, the dynamic characteristic data, the predicted maximum sag and the current maximum sag.

Optionally, through reasonable derivation, an expression of the current specific load parameter can be obtained. Based on the expression, the current specific load parameter of the target power transmission line can be calculated based on the static characteristic data, the dynamic characteristic data, the predicted maximum sag and the current maximum sag.

In this embodiment, the dynamic characteristic data, the static characteristic data and the current specific load parameter are obtained through different methods or approaches respectively, which ensures the reliability of the data sources and further guarantees the accuracy of the obtained data.

Optionally, in an embodiment, as shown in FIG. 8, a method for determining the current specific load parameter of the target power transmission line is provided, which specifically includes the following steps S801-S803.

In the step S801, a product of the mass parameter and the gravitational acceleration is taken as a first intermediate parameter.

The mass parameter is a parameter characterizing the mass of the target power transmission line. In the embodiments of the present application, the mass parameter can be the mass per unit length of the target power transmission line.

Optionally, considering that the self-weight specific load is related to the mass property of the target power transmission line, the self-weight specific load can be determined based on the mass parameter, the gravitational acceleration and the cross-sectional area. First, the product of the mass parameter and the gravitational acceleration is taken as the first intermediate parameter. Specifically, the first intermediate parameter can be expressed by the following formula (2):

$$z_1 = qg \qquad\qquad (2)$$

where $z_1$ is the first intermediate parameter, q is the mass parameter, i.e., the mass per unit length of the target power transmission line with the unit of kg/km, and g is the gravitational acceleration, which can be taken as $9.80665$ m/s$^2$.

In the step S802, the self-weight specific load is determined based on a ratio between the first intermediate parameter and the cross-sectional area.

Optionally, the self-weight specific load is determined based on the ratio between the first intermediate parameter and the cross-sectional area, which can be expressed by the following formula (3):

$$\gamma_1 = \frac{z_1}{A} \times 10^{-3} = \frac{qg}{A} \times 10^{-3} \qquad\qquad (3)$$

where $\gamma_1$ is the self-weight specific load with the unit of MPa/m, and A is the cross-sectional area with the unit of mm$^2$.

In the step S803, a comprehensive specific load is determined based on the self-weight specific load, the predicted maximum sag, the current maximum sag, the static characteristic data and the dynamic characteristic data.

Optionally, through reasonable derivation, the expression of the comprehensive specific load can be obtained. Based on the expression, the comprehensive specific load can be calculated based on the self-weight specific load, the predicted maximum sag, the current maximum sag, the static characteristic data and the dynamic characteristic data.

In this embodiment, by introducing the first intermediate parameter, a method for calculating the self-weight specific load is provided. Moreover, based on the self-weight specific load, the predicted maximum sag, the current maximum sag, the static characteristic data and the dynamic characteristic data, a method for determining the comprehensive specific load is provided.

Optionally, in the embodiments of the present application, the comprehensive specific load refers to the specific load of the target power transmission line under the ice-and-wind environment, i.e., the specific load comprehensively considering the self-weight, the ice weight and the wind pressure. Therefore, an expression of a horizontal stress of the target power transmission line can be obtained through the relationship between the maximum sag, the stress and the specific load, and then the comprehensive specific load can be calculated based on the horizontal stress expression.

Specifically, by transforming the oblique parabola sag formula, a circumferential stress at the center of the span of the target power transmission line can be obtained as follows:

$$\sigma_c = \frac{\gamma l^2}{8 f_{max} cos^2 \beta} \qquad (4)$$

where $\sigma_c$ is the circumferential stress at the center of the span, $\gamma$ is the comprehensive specific load of the target power transmission line, $f_{max}$ is the maximum sag, $l$ is the horizontal span, and $\beta$ is the height-difference angle.

Under the ideal environment (i.e., the ice-free and wind-free environment) and the abnormal environment (i.e., the ice-and-wind environment), the relationship between an axial stress and the comprehensive specific load of the target power transmission line in these two environments can be obtained based on the parabolic state equation of the target power transmission line, which can be specifically expressed by the following formula (5):

$$\sigma_{c2} - \frac{E\gamma_2^2 l^2}{24\sigma_{c2}^2} = \sigma_{c1} - \frac{E\gamma_1^2 l^2}{24\sigma_{c1}^2} - \alpha E(t_2 - t_1) \qquad (5)$$

where $\sigma_{c2}$ is the axial stress in the abnormal environment, $\sigma_{c1}$ is the axial stress in the ideal environment, $E$ is the elasticity coefficient of the target power transmission line, $\gamma_1$ is the self-weight specific load, $\gamma_2$ is the comprehensive specific load, $\alpha$ is the temperature expansion coefficient of the target power transmission line, $t_1$ is the first temperature of the target power transmission line in the ideal environment, and $t_2$ is the second temperature of the target power transmission line in the abnormal environment.

Further, by combining the above-mentioned formula (4) and formula (5), the relational expression between the comprehensive specific load and the self-weight specific load can be obtained. Specifically, on this basis, in an embodiment, as shown in FIG. 9, a method for determining the comprehensive specific load of the target power transmission line is provided, which specifically includes the following steps S901-S904.

In the step S901, a ratio of a product of the current maximum sag and the self-weight specific load to the predicted maximum sag is taken as a second intermediate parameter.

Optionally, taking the ratio of the product of the current maximum sag and the self-weight specific load to the predicted maximum sag as the second intermediate parameter can be expressed by the following formula (6):

$$z_2 = \frac{f_2 \gamma_1}{f_1} \qquad (6)$$

where $z_2$ is the second intermediate parameter, $f_2$ is the current maximum sag, $f_1$ is the predicted maximum sag, and $\gamma_1$ is the self-weight specific load.

In the step S902, a third intermediate parameter is determined based on the current maximum sag, the predicted maximum sag, the elasticity coefficient, the horizontal span and the height-difference angle.

Optionally, determining the third intermediate parameter based on the current maximum sag, the predicted maximum sag, the elasticity coefficient, the horizontal span and the height-difference angle can be expressed by the following formula (7):

$$z_3 = \frac{64 E f_2 (f_1^2 - f_2^2) cos^6 \beta}{3l^2} \qquad (7)$$

where $z_3$ is the third intermediate parameter.

In the step S903, a fourth intermediate parameter is determined based on the temperature expansion coefficient, the current maximum sag, the first temperature, the second temperature, the height-difference angle and the horizontal span.

Optionally, determining the fourth intermediate parameter based on the temperature expansion coefficient, the current maximum sag, the first temperature, the second temperature, the height-difference angle and the horizontal span can be expressed by the following formula (8):

$$z_4 = \frac{8\alpha E f_2 (t_2 - t_1) cos^2 \beta}{l^2} \qquad (8)$$

where $z_4$ is the fourth intermediate parameter, and $\alpha$ is the temperature expansion coefficient.

In the step S904, a difference between a difference between the second intermediate parameter and the third intermediate parameter and the fourth intermediate parameter is taken as the comprehensive specific load.

Optionally, taking the difference between the difference between the second intermediate parameter and the third intermediate parameter and the fourth intermediate parameter as the comprehensive specific load can be expressed by the following formula (9):

$$\gamma_2 = z_2 - z_3 - z_4 = \frac{f_2 \gamma_1}{f_1} - \frac{64 E f_2 (f_1^2 - f_2^2) cos^6 \beta}{3l^2} - \frac{8\alpha E f_2 (t_2 - t_1) cos^2 \beta}{l^2} \qquad (9)$$

where $\gamma_2$ is the comprehensive specific load.

In this embodiment, by introducing the second intermediate parameter, the third intermediate parameter and the fourth intermediate parameter, a method for quickly and accurately calculating the comprehensive specific load is provided.

It should be noted that the comprehensive specific load of the target power transmission line is obtained by the vector sum of the vertical specific load and the horizontal specific load of the target power transmission line. The vertical specific load includes the self-weight specific load and the ice-weight specific load. The self-weight specific load is determined by the self-properties, and the ice-weight specific load is affected by the icing thickness. The horizontal specific load mainly considers the icing wind-pressure specific load.

Optionally, the comprehensive specific load is obtained by the vector sum of the vertical specific load and the horizontal specific load of the target power transmission line, which can be specifically expressed by the following formula (10):

$$\gamma_2 = \sqrt{\gamma_v^2 + \gamma_h^2} \qquad (10)$$

where $\gamma_v$ is the vertical specific load, and $\gamma_h$ is the horizontal specific load.

Optionally, the vertical specific load includes the self-weight specific load and the ice-weight specific load, which can be expressed by the following formula (11):

$$\gamma_v = \gamma_1 + \gamma_{ice} \qquad (11)$$

where $\gamma_{ice}$ is the ice-weight specific load.

The relationship between the vertical specific load and the horizontal specific load can be expressed by the following formula (12):

$$\gamma_h = \gamma_v tan\eta \qquad (12)$$

where $\eta$ is the wind deflection angle.

Further, by combining formula (10), formula (11) and formula (12), the relational expression between the ice-weight specific load, the self-weight specific load and the comprehensive specific load can be obtained, which is specifically expressed by the following formula (13):

$$\gamma_{ice} = \gamma_2 cos\eta - \gamma_1 \qquad (13).$$

Meanwhile, the relationship between the ice-weight specific load and the icing thickness is as follows:

$$\gamma_{ice} = \frac{\rho \pi g b (b+d)}{A} \qquad (14)$$

where $\rho$ is the icing density, which can be taken as $0.9 \times 10^{-3}$ kg/cm$^3$ in the embodiments of the present application, d is the outer diameter of the target power transmission line with the unit of mm, and b is the icing thickness.

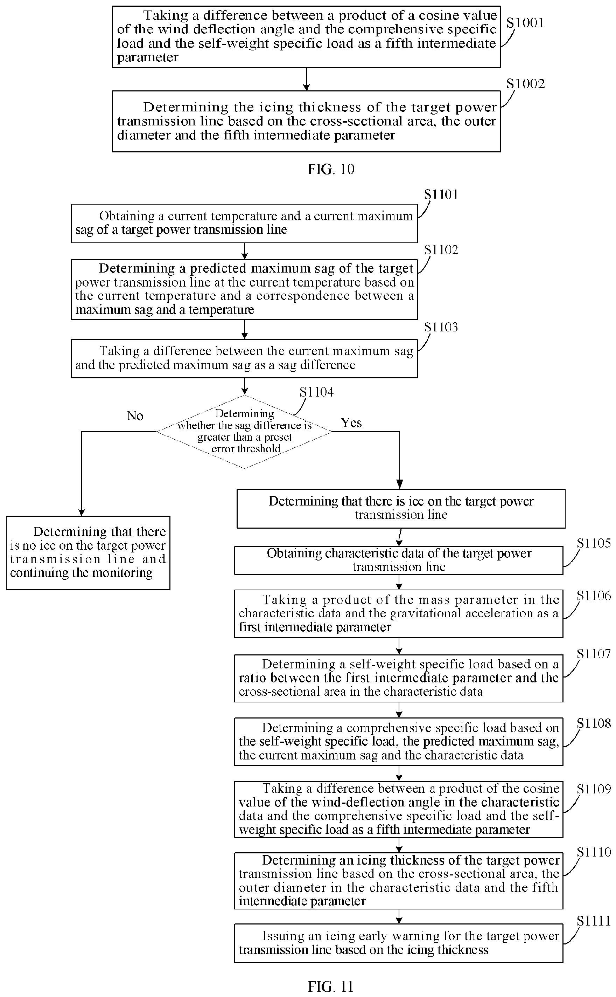

Therefore, by combining formula (13) and formula (14), the relational expression between the icing thickness, the comprehensive specific load and the self-weight specific load can be derived. On this basis, as shown in FIG. 10, a method for determining the icing thickness of the target power transmission line is provided, which specifically includes the following steps S1001-S1002.

In the step S1001, a difference between a product of the cosine value of the wind deflection angle and the comprehensive specific load and the self-weight specific load is taken as a fifth intermediate parameter.

Optionally, taking the difference between the product of the cosine value of the wind deflection angle and the comprehensive specific load and the self-weight specific load as the fifth intermediate parameter can be expressed by the following formula (15):

$$z_5 = \gamma_2 cos\eta - \gamma_1 \qquad (15)$$

where $z_5$ is the fifth intermediate parameter.

In the step S1002, the icing thickness of the target power transmission line is determined based on the cross-sectional area, the outer diameter and the fifth intermediate parameter.

Optionally, determining the icing thickness of the target power transmission line based on the cross-sectional area, the outer diameter and the fifth intermediate parameter can be expressed by the following formula (16):

$$b = \frac{\sqrt{d^2 + \frac{4 A z_5}{\rho \pi g}} - d}{2} \qquad (16).$$

In this embodiment, by introducing the fifth intermediate parameter, the cross-sectional area and the outer diameter, a method for quickly and accurately determining the icing thickness of the target power transmission line is provided.

The equivalent ice thickness calculation obtained using the temperature-sag method of the present application can achieve a measurement accuracy better than $\pm$1mm when the PTK precision is $\pm$2cm. The accuracy is related to the span and sag. In a practical example, the horizontal span is 400 meters, the initial sag is 15 meters, the changed sag is 15.05 meters, the transmission line is a 400/35 steel-core aluminum stranded wire (with an aluminum conductor cross-section of 400mm$^2$ and a steel core cross-section of 35mm$^2$), and at this point, the variation in icing thickness is within $\pm$1mm. In the case where the span is 400m and the sag is 10m, the accuracy can be better than $\pm$0.5mm.

In some of the embodiments described above, data such as wind speed, tilt angle, and high-precision positioning are integrated for ice accretion monitoring, offering self-calibration features compared to traditional methods.

FIG. 11 is a flowchart of a method for power transmission line icing warning according to another embodiment. Based on the above-mentioned embodiments, the present embodiment provides an optional example of the method for power transmission line icing warning. Referring to FIG. 11, the specific implementation process includes steps S1101-S1111.

In the step S1101, a current line temperature and a current maximum sag of the target power transmission line is obtained.

In the step S1102, a predicted maximum sag of the target power transmission line at the current line temperature is determined based on the current line temperature and a correspondence between a maximum sag and a temperature.

In some embodiments, historical monitoring data of the target power transmission line is obtained through the monitoring device installed on the target power transmission line. The historical monitoring data includes historical line temperatures and historical maximum sags at different historical times. The historical monitoring data of the target power transmission line in an ideal environment is selected from the historical monitoring data as the target monitoring data. The ideal environment includes at least an ice-free and wind-free environment. The maximum sag-line temperature correspondence for the target power transmission line is constructed based on the target monitoring data.

In the step S1103, a difference between the current maximum sag and the predicted maximum sag is taken as a sag difference.

In the step S1104, whether the sag difference is greater than a preset error threshold is determined. If yes, it is determined that there is ice on the target power transmission line, and the step S1105 is performed. If not, it is determined that there is no ice on the target power transmission line, and the monitoring continues.

In the step S1105, characteristic data of the target power transmission line is obtained.

The characteristic data includes static characteristic data and dynamic characteristic data. The static characteristic data includes an outer diameter, a cross-sectional area, a mass parameter, a temperature expansion coefficient and an elasticity coefficient of the target power transmission line. The dynamic characteristic data includes a horizontal span, a height-difference angle, a wind deflection angle, a first temperature in an ideal environment and a second temperature in an abnormal environment of the target power transmission line. The current specific load parameter includes a self-weight specific load in the ideal environment and a comprehensive specific load in the abnormal environment. The ideal environment includes at least an ice-free and wind-free environment, and the abnormal environment includes at least an environment with ice and/or wind.

Optionally, the dynamic characteristic data can be obtained through the monitoring device installed on the target power transmission line, and the static characteristic data can be determined based on attribute information of the target power transmission line. The current specific load parameter of the target power transmission line is determined based on the static characteristic data, the dynamic characteristic data, the predicted maximum sag and the current maximum sag.

In the step S1106, a product of the mass parameter in the characteristic data and the gravitational acceleration is taken as a first intermediate parameter.

In the step S1107, a self-weight specific load is determined based on a ratio between the first intermediate parameter and the cross-sectional area in the characteristic data.

In the step S1108, a comprehensive specific load is determined based on the self-weight specific load, the predicted maximum sag, the current maximum sag and the characteristic data.

Optionally, a ratio of a product of the current maximum sag and the self-weight specific load to the predicted maximum sag is taken as a second intermediate parameter. A third intermediate parameter is determined based on the current maximum sag, the predicted maximum sag, the elasticity coefficient, the horizontal span and the height-difference angle. A fourth intermediate parameter is determined based on the temperature expansion coefficient, the current maximum sag, the first temperature, the second temperature, the height-difference angle and the horizontal span. A difference between the difference between the second intermediate parameter and the third intermediate parameter and the fourth intermediate parameter is taken as the comprehensive specific load.

In the step S1109, a difference between a product of the cosine value of the wind deflection angle in the characteristic data and the comprehensive specific load and the self-weight specific load is taken as a fifth intermediate parameter.

In the step S1110, an icing thickness of the target power transmission line is determined based on the cross-sectional area, the outer diameter in the characteristic data and the fifth intermediate parameter.

In the step S1111, an icing warning for the target power transmission line is issued based on the icing thickness.

For the specific processes of the above S1101-S1111, reference can be made to the descriptions of the previously-described method in the embodiments. The implementation principles and technical effects are similar, and thus will not be repeated here.

It should be understood that although the steps in the flowcharts involved in the above-mentioned embodiments are sequentially shown as indicated by the arrows, these steps are not necessarily executed in the order indicated by the arrows. Unless explicitly stated in this text, there is no strict order limit for the execution of these steps, and these steps can be executed in other orders. Moreover, at least some of the steps in the flowcharts involved in the above-mentioned embodiments may include multiple sub-steps or multiple stages. These sub-steps or stages are not necessarily executed and completed at the same time, but can be executed at different times. The execution order of these sub-steps or stages is not necessarily sequential, but can be alternated or taken turns with at least some of the sub-steps or stages in other steps or other steps.

In some embodiments, sensors or sensing units for detecting various physical quantities, such as temperature sensors, humidity sensors, current detection units, gyroscopes, positioning sensors, image acquisition sensors, etc., are integrated into a single device to enable the detection of multiple physical quantities.

Based on the same inventive concept, the embodiments of the present application also provide an apparatus for power transmission line icing warning, which implements the above-described method for power transmission line icing warning. The solution provided by the apparatus to solve the problem is similar to the solution described in the above method. Therefore, for the specific limitations in one or more embodiments of the apparatus for power transmission line icing warning provided below, reference can be made to the limitations described in the above method for power transmission line icing warning, and details will not be repeated here.

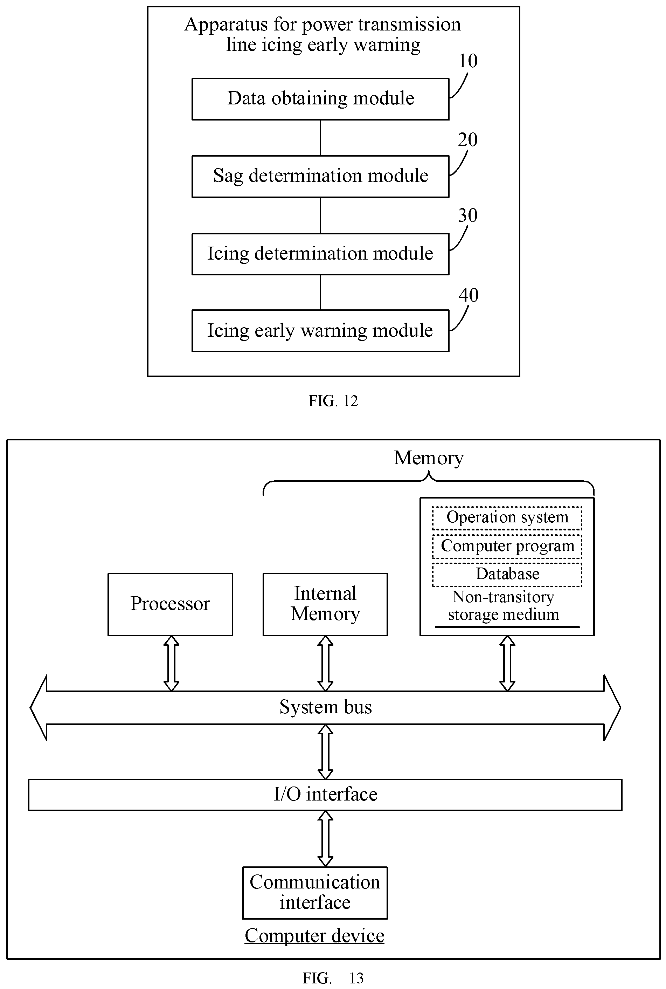

In an embodiment, as shown in FIG. 12, an apparatus for power transmission line icing warning is provided, which includes a data obtaining module 10, a sag determination module 20, an icing determination module 30 and an icing warning module 40.

The data obtaining module 10 is configured to obtain a current line temperature and a current maximum sag of a target power transmission line.

The sag determination module 20 is configured to determine a predicted maximum sag of the target power transmission line at the current line temperature based on the current line temperature and a correspondence between a maximum sag and a temperature.

The icing determination module 30 is configured to determine whether there is ice on the target power transmission line based on the current maximum sag and the predicted maximum sag.

The icing warning module 40 is configured to issue an icing warning for the target power transmission line when it is determined that there is ice on the target power transmission line.

According to the above-mentioned apparatus for power transmission line icing warning, the current line temperature and the current maximum sag of the target power transmission line are obtained. Then, based on the current line temperature and the maximum sag-line temperature correspondence, the predicted maximum sag of the target power transmission line at the current line temperature is determined. Subsequently, based on the current maximum sag and the predicted maximum sag, it is determined whether there is ice on the target power transmission line. If it is determined that there is ice on the target power transmission line, an icing warning for the target power transmission line is issued. In this solution, by introducing the maximum sag-line temperature correspondence, the maximum sags of the target power transmission line under different line temperatures can be accurately reflected. Thus, based on the correspondence, the predicted maximum sag of the target power transmission line at the current line temperature, i.e., the maximum sag when no icing occurs, can be accurately determined. Further, based on the current maximum sag and the predicted maximum sag, it can be rationally and accurately determined whether there is ice on the target power transmission line, enabling an accurate icing warning for the target power transmission line.

In an embodiment, the apparatus for power transmission line icing warning further includes a data monitoring module, a data selection module, and a relationship determination module.

The data monitoring module is configured to obtain historical monitoring data of the target power transmission line through a monitoring device installed on the target power transmission line. The historical monitoring data includes historical line temperatures and historical maximum sags at different historical times.

The data selection module is configured to select historical monitoring data of the target power transmission line in an ideal environment from the historical monitoring data as the target monitoring data. The ideal environment includes at least an ice-free and wind-free environment.

The relationship determination module is configured to construct a maximum sag-line temperature correspondence for the target power transmission line based on the target monitoring data.

In an embodiment, the icing determination module 30 is specifically configured to take a difference between the current maximum sag and the predicted maximum sag as the sag difference, and if the sag difference is greater than a preset error threshold, determine that there is ice on the target transmission line.

In an embodiment, the icing warning module 40 includes a data obtaining unit, a thickness determination unit, and an icing warning unit.

The data obtaining unit is configured to obtain characteristic data and a current specific load parameter of the target power transmission line.

The thickness determination unit is configured to determine an icing thickness of the target power transmission line based on the characteristic data and the current specific load parameter.

The icing warning unit is configured to issue an icing warning for the target power transmission line based on the icing thickness.

In an embodiment, the characteristic data includes static characteristic data and dynamic characteristic data, and the data obtaining unit includes a first sub-obtaining unit, a second sub-obtaining unit, and a third sub-obtaining unit.

The first sub-obtaining unit is configured to obtain the dynamic characteristic data through the monitoring device installed on the target power transmission line.

The second sub-obtaining unit is configured to determine the static characteristic data based on the attribute information of the target power transmission line.

The third sub-obtaining unit is configured to determine the current specific load parameter of the target power transmission line based on the static characteristic data, the dynamic characteristic data, the predicted maximum sag and the current maximum sag.

In an embodiment, the static characteristic data includes an outer diameter, a cross-sectional area, a mass parameter, a temperature expansion coefficient and an elasticity coefficient of the target power transmission line. The dynamic characteristic data includes a horizontal span, a height-difference angle, a wind deflection angle, a first temperature in an ideal environment and a second temperature in an abnormal environment of the target power transmission line. The current specific load parameter includes a self-weight specific load in the ideal environment and a comprehensive specific load in the abnormal environment. The ideal environment includes at least an ice-free and wind-free environment, and the abnormal environment includes at least an environment with ice and/or wind.

In an embodiment, the third sub-obtaining unit includes a first subunit, a second subunit, and a third subunit.

The first subunit is configured to take a product of the mass parameter and the gravitational acceleration as the first intermediate parameter.

The second subunit is configured to determine a self-weight specific load based on a ratio between the first intermediate parameter and the cross-sectional area.

The third subunit is configured to determine a comprehensive specific load based on the self-weight specific load, the predicted maximum sag, the current maximum sag, the static characteristic data, and the dynamic characteristic data.

In an embodiment, the third subunit is configured to take a ratio of the product of the current maximum sag and the self-weight specific load to the predicted maximum sag as a second intermediate parameter, determine a third intermediate parameter based on the current maximum sag, the predicted maximum sag, the elasticity coefficient, the horizontal span, and the height-difference angle, determine a fourth intermediate parameter based on the temperature expansion coefficient, the current maximum sag, the first temperature, the second temperature, the height-difference angle, and the horizontal span, and take a difference between a difference of the second intermediate parameter and the third intermediate parameter and the fourth intermediate parameter as the comprehensive specific load.

In an embodiment, the thickness determination unit is configured to take a difference between a product of the cosine value of the wind deflection angle and the comprehensive specific load and the self-weight specific load as a fifth intermediate parameter, and determine the icing thickness of the target power transmission line based on the cross-sectional area, the outer diameter, and the fifth intermediate parameter.

All or part of each module in the above-mentioned apparatus for power transmission line icing warning can be implemented through software, hardware, and their combination. Each of the above-mentioned modules can be embedded in the processor of a computer device in hardware form or independent of it. They can also be stored in the memory of the computer device in software form, so that the processor can call and execute the operations corresponding to each module.

In an exemplary embodiment, a computer device is provided. This computer device can be a server, and its internal structure diagram is shown in FIG. 13. The computer device includes a processor, a memory, an input/output (I/O) interface, and a communication interface. The processor, the memory, and the I/O interface are connected through the system bus, and the communication interface is connected to the system bus through the I/O interface. The processor of the computer device is used to provide computing and control capabilities. The memory of the computer device includes a non-transitory storage medium and an internal memory. The non-transitory storage medium stores an operating system, a computer program, and a database. The internal memory provides an environment for the operation of the operating system and the computer program in the non-transitory storage medium. The I/O interface of the computer device is used for the exchange of information between the processor and external devices. The communication interface of the computer device is used for network-connected communication with external terminals. When the computer program is executed by the processor, a method for power transmission line icing warning is implemented.

Those skilled in the art can understand that the structure shown in FIG. 13 is only a block diagram of the partial structure related to the solution of the present application and does not constitute a limitation on the computer device to which the solution of the present application is applied. A specific computer device may include more or fewer components than those shown in the figure, or combine some components, or have a different component arrangement.

In an embodiment, a computer device is provided, which includes a memory and a processor. A computer program is stored in the memory. When executing the computer program, the processor is configured to perform a method for power transmission line icing warning according to any of the embodiments described above. Specifically, when executing the computer program, the processor is configured to obtain a current line temperature and a current maximum sag of a target power transmission line, determine a predicted maximum sag of the target power transmission line at the current line temperature based on the current line temperature and a maximum sag-line temperature correspondence, determine whether there is ice on the target power transmission line based on the current maximum sag and the predicted maximum sag; and issue an icing warning for the target power transmission line when it is determined that there is ice on the target power transmission line.

In an embodiment, when executing the computer program, the processor is configured to obtain historical monitoring data of the target power transmission line through the monitoring device installed on the target power transmission line, where the historical monitoring data includes historical line temperatures and historical maximum sags at different historical times, select the historical monitoring data of the target power transmission line in an ideal environment from the historical monitoring data as the target monitoring data, where the ideal environment includes at least an ice-free and wind-free environment, and construct the maximum sag-line temperature correspondence for the target power transmission line based on the target monitoring data.

In an embodiment, when executing the computer program to determine whether there is ice on the target power transmission line based on the current maximum sag and the predicted maximum sag, the processor is also configured to take a difference between the current maximum sag and the predicted maximum sag as the sag difference, and if the sag difference is greater than a preset error threshold, determine that there is ice on the target transmission line.

In an embodiment, when executing the computer program to issue an icing warning for the target power transmission line, the processor is also configured to obtain characteristic data and a current specific load parameter of the target power transmission line, determine an icing thickness of the target power transmission line based on the characteristic data and the current specific load parameter, and issue an icing warning for the target power transmission line based on the icing thickness.

In an embodiment, the characteristic data includes static characteristic data and dynamic characteristic data. When executing the computer program to obtain the characteristic data and the current specific load parameter of the target power transmission line, the processor is also configured to obtain the dynamic characteristic data through the monitoring device installed on the target power transmission line, determine the static characteristic data based on attribute information of the target power transmission line, and determine the current specific load parameter of the target power transmission line based on the static characteristic data, the dynamic characteristic data, the predicted maximum sag and the current maximum sag.

In an embodiment, the static characteristic data includes an outer diameter, a cross-sectional area, a mass parameter, a temperature expansion coefficient, and an elasticity coefficient of the target power transmission line. The dynamic characteristic data includes a horizontal span, a height-difference angle, a wind deflection angle, a first temperature in an ideal environment, and a second temperature in an abnormal environment of the target power transmission line. The current specific load parameter includes a self-weight specific load in the ideal environment and a comprehensive specific load in the abnormal environment. The ideal environment includes at least an ice-free and wind-free environment, and the abnormal environment includes at least an environment with ice and/or wind.

In an embodiment, when executing the computer program to determine the current specific load parameter of the target power transmission line based on the static characteristic data, the dynamic characteristic data, the predicted maximum sag, and the current maximum sag, the processor is also configured to take a product of a mass parameter and the gravitational acceleration as a first intermediate parameter, determine a self-weight specific load based on a ratio between the first intermediate parameter and the cross-sectional area, and determine the comprehensive specific load based on the self-weight specific load, the predicted maximum sag, the current maximum sag, the static characteristic data, and the dynamic characteristic data.

In an embodiment, when executing the computer program to determine the comprehensive specific load of the target power transmission line based on the self-weight specific load, the predicted maximum sag, the current maximum sag, the static characteristic data, and the dynamic characteristic data of the target power transmission line, the processor is also configured to take the ratio of the product of the current maximum sag and the self-weight specific load to the predicted maximum sag as a second intermediate parameter, determine a third intermediate parameter based on the current maximum sag, the predicted maximum sag, the elasticity coefficient, the horizontal span, and the height-difference angle, determine a fourth intermediate parameter based on the temperature expansion coefficient, the current maximum sag, the first temperature, the second temperature, the height-difference angle, and the horizontal span, and take a difference between a difference of the second intermediate parameter and the third intermediate parameter and the fourth intermediate parameter as the comprehensive specific load.

In an embodiment, when executing the computer program to determine the icing thickness of the target power transmission line based on the characteristic data and the current specific load parameter, the processor is also configured to take a difference between a product of the cosine value of the wind deflection angle and the comprehensive specific load and the self-weight specific load as a fifth intermediate parameter, and determine the icing thickness of the target power transmission line based on the cross-sectional area, outer diameter, and the fifth intermediate parameter.

In an embodiment, a non-transitory computer-readable storage medium is provided, in which a computer program is stored. The computer program, when executed by a processor, causes the processor to perform a method for power transmission line icing warning according to any of the embodiments described above. Specifically, the computer program, when executed by a processor, causes the processor to obtain a current line temperature and a current maximum sag of a target power transmission line, determine a predicted maximum sag of the target power transmission line at the current line temperature based on the current line temperature and a maximum sag-line temperature correspondence, determine whether there is ice on the target power transmission line based on the current maximum sag and the predicted maximum sag; and issue an icing warning for the target power transmission line when it is determined that there is ice on the target power transmission line.

In an embodiment, when executing the computer program, the processor is configured to obtain historical monitoring data of the target power transmission line through the monitoring device installed on the target power transmission line, where the historical monitoring data includes historical line temperatures and historical maximum sags at different historical times, select the historical monitoring data of the target power transmission line in an ideal environment from the historical monitoring data as the target monitoring data, where the ideal environment includes at least an ice-free and wind-free environment, and construct the maximum sag-line temperature correspondence for the target power transmission line based on the target monitoring data.

In an embodiment, when executing the computer program to determine whether there is ice on the target power transmission line based on the current maximum sag and the predicted maximum sag, the processor is also configured to take a difference between the current maximum sag and the predicted maximum sag as the sag difference, and if the sag difference is greater than a preset error threshold, determine that there is ice on the target transmission line.

In an embodiment, when executing the computer program to issue an icing warning for the target power transmission line, the processor is also configured to obtain characteristic data and a current specific load parameter of the target power transmission line, determine an icing thickness of the target power transmission line based on the characteristic data and the current specific load parameter, and issue an icing warning for the target power transmission line based on the icing thickness.

In an embodiment, the characteristic data includes static characteristic data and dynamic characteristic data. When executing the computer program to obtain the characteristic data and the current specific load parameter of the target power transmission line, the processor is also configured to obtain the dynamic characteristic data through the monitoring device installed on the target power transmission line, determine the static characteristic data based on attribute information of the target power transmission line, and determine the current specific load parameter of the target power transmission line based on the static characteristic data, the dynamic characteristic data, the predicted maximum sag and the current maximum sag.

In an embodiment, the static characteristic data includes an outer diameter, a cross-sectional area, a mass parameter, a temperature expansion coefficient, and an elasticity coefficient of the target power transmission line. The dynamic characteristic data includes a horizontal span, a height-difference angle, a wind deflection angle, a first temperature in an ideal environment, and a second temperature in an abnormal environment of the target power transmission line. The current specific load parameter includes a self-weight specific load in the ideal environment and a comprehensive specific load in the abnormal environment. The ideal environment includes at least an ice-free and wind-free environment, and the abnormal environment includes at least an environment with ice and/or wind.

In an embodiment, when executing the computer program to determine the current specific load parameter of the target power transmission line based on the static characteristic data, the dynamic characteristic data, the predicted maximum sag, and the current maximum sag, the processor is also configured to take a product of a mass parameter and the gravitational acceleration as a first intermediate parameter, determine a self-weight specific load based on a ratio between the first intermediate parameter and the cross-sectional area, and determine the comprehensive specific load based on the self-weight specific load, the predicted maximum sag, the current maximum sag, the static characteristic data, and the dynamic characteristic data.

In an embodiment, when executing the computer program to determine the comprehensive specific load of the target power transmission line based on the self-weight specific load, the predicted maximum sag, the current maximum sag, the static characteristic data, and the dynamic characteristic data of the target power transmission line, the processor is also configured to take the ratio of the product of the current maximum sag and the self-weight specific load to the predicted maximum sag as a second intermediate parameter, determine a third intermediate parameter based on the current maximum sag, the predicted maximum sag, the elasticity coefficient, the horizontal span, and the height-difference angle, determine a fourth intermediate parameter based on the temperature expansion coefficient, the current maximum sag, the first temperature, the second temperature, the height-difference angle, and the horizontal span, and take a difference between a difference of the second intermediate parameter and the third intermediate parameter and the fourth intermediate parameter as the comprehensive specific load.

In an embodiment, when executing the computer program to determine the icing thickness of the target power transmission line based on the characteristic data and the current specific load parameter, the processor is also configured to take a difference between a product of the cosine value of the wind deflection angle and the comprehensive specific load and the self-weight specific load as a fifth intermediate parameter, and determine the icing thickness of the target power transmission line based on the cross-sectional area, outer diameter, and the fifth intermediate parameter.

In an embodiment, a computer program product is provided, which includes a computer program. The computer program, when executed by a processor, causes the processor to perform a method for power transmission line icing warning according to any of the embodiments described above. Specifically, the computer program, when executed by a processor, causes the processor to obtain a current line temperature and a current maximum sag of a target power transmission line, determine a predicted maximum sag of the target power transmission line at the current line temperature based on the current line temperature and a maximum sag-line temperature correspondence, determine whether there is ice on the target power transmission line based on the current maximum sag and the predicted maximum sag; and issue an icing warning for the target power transmission line when it is determined that there is ice on the target power transmission line.

In an embodiment, when executing the computer program, the processor is configured to obtain historical monitoring data of the target power transmission line through the monitoring device installed on the target power transmission line, where the historical monitoring data includes historical line temperatures and historical maximum sags at different historical times, select the historical monitoring data of the target power transmission line in an ideal environment from the historical monitoring data as the target monitoring data, where the ideal environment includes at least an ice-free and wind-free environment, and construct the maximum sag-line temperature correspondence for the target power transmission line based on the target monitoring data.

In an embodiment, when executing the computer program to determine whether there is ice on the target power transmission line based on the current maximum sag and the predicted maximum sag, the processor is also configured to take a difference between the current maximum sag and the predicted maximum sag as the sag difference, and if the sag difference is greater than a preset error threshold, determine that there is ice on the target transmission line.

In an embodiment, when executing the computer program to issue an icing warning for the target power transmission line, the processor is also configured to obtain characteristic data and a current specific load parameter of the target power transmission line, determine an icing thickness of the target power transmission line based on the characteristic data and the current specific load parameter, and issue an icing warning for the target power transmission line based on the icing thickness.

In an embodiment, the characteristic data includes static characteristic data and dynamic characteristic data. When executing the computer program to obtain the characteristic data and the current specific load parameter of the target power transmission line, the processor is also configured to obtain the dynamic characteristic data through the monitoring device installed on the target power transmission line, determine the static characteristic data based on attribute information of the target power transmission line, and determine the current specific load parameter of the target power transmission line based on the static characteristic data, the dynamic characteristic data, the predicted maximum sag and the current maximum sag.

In an embodiment, the static characteristic data includes an outer diameter, a cross-sectional area, a mass parameter, a temperature expansion coefficient, and an elasticity coefficient of the target power transmission line. The dynamic characteristic data includes a horizontal span, a height-difference angle, a wind deflection angle, a first temperature in an ideal environment, and a second temperature in an abnormal environment of the target power transmission line. The current specific load parameter includes a self-weight specific load in the ideal environment and a comprehensive specific load in the abnormal environment. The ideal environment includes at least an ice-free and wind-free environment, and the abnormal environment includes at least an environment with ice and/or wind.

In an embodiment, when executing the computer program to determine the current specific load parameter of the target power transmission line based on the static characteristic data, the dynamic characteristic data, the predicted maximum sag, and the current maximum sag, the processor is also configured to take a product of a mass parameter and the gravitational acceleration as a first intermediate parameter, determine a self-weight specific load based on a ratio between the first intermediate parameter and the cross-sectional area, and determine the comprehensive specific load based on the self-weight specific load, the predicted maximum sag, the current maximum sag, the static characteristic data, and the dynamic characteristic data.

In an embodiment, when executing the computer program to determine the comprehensive specific load of the target power transmission line based on the self-weight specific load, the predicted maximum sag, the current maximum sag, the static characteristic data, and the dynamic characteristic data of the target power transmission line, the processor is also configured to take the ratio of the product of the current maximum sag and the self-weight specific load to the predicted maximum sag as a second intermediate parameter, determine a third intermediate parameter based on the current maximum sag, the predicted maximum sag, the elasticity coefficient, the horizontal span, and the height-difference angle, determine a fourth intermediate parameter based on the temperature expansion coefficient, the current maximum sag, the first temperature, the second temperature, the height-difference angle, and the horizontal span, and take a difference between a difference of the second intermediate parameter and the third intermediate parameter and the fourth intermediate parameter as the comprehensive specific load.

In an embodiment, when executing the computer program to determine the icing thickness of the target power transmission line based on the characteristic data and the current specific load parameter, the processor is also configured to take a difference between a product of the cosine value of the wind deflection angle and the comprehensive specific load and the self-weight specific load as a fifth intermediate parameter, and determine the icing thickness of the target power transmission line based on the cross-sectional area, outer diameter, and the fifth intermediate parameter.

It should be noted that the data involved in the present application (including but not limited to data for analysis, stored data, displayed data, etc.) are all information and data fully authorized by all parties, and the collection, use, and processing of relevant data need to comply with relevant regulations.

Those of ordinary skill in the art can understand that all or part of the processes in the methods of the above-mentioned embodiments can be completed by instructing relevant hardware through a computer program. The computer program can be stored in a non-transitory computer-readable storage medium. When the computer program is executed, it may include the processes of the above-mentioned method embodiments. Among them, any reference to a memory, database, or other medium used in the embodiments provided in the present application may include at least one of non-transitory memory and transitory memory. Non-transitory memory may include Read-Only Memory (ROM), magnetic tape, floppy disk, flash memory, optical memory, high-density embedded non-transitory memory, Resistive Random Access Memory (ReRAM), Magnetoresistive Random Access Memory (MRAM), Ferroelectric Random Access Memory (FRAM), Phase Change Memory (PCM), graphene memory, etc. Transitory memory may include Random Access Memory (RAM) or an external cache memory, etc. By way of illustration and not limitation, RAM can be in various forms, such as Static Random Access Memory (SRAM) or Dynamic Random Access Memory (DRAM). The databases involved in the embodiments provided in the present application may include at least one of relational databases and non-relational databases. Non-relational databases may include distributed databases based on blockchain, etc., without limitation. The processors involved in the embodiments provided in the present application may be general-purpose processors, central processing units, graphics processors, digital signal processors, programmable logic devices, data processing logic devices based on quantum computing, etc., without limitation.

The technical features of the above embodiments can be combined arbitrarily. To make the description concise, all possible combinations of the technical features in the above embodiments are not described. However, as long as there is no contradiction in the combination of these technical features, it should be considered within the scope described in this specification.

The above-mentioned embodiments only represent several implementation modes of the present application. The description is relatively specific and detailed, but it should not be construed as a limitation on the patent scope of the present application. It should be noted that for those of ordinary skill in the art, without departing from the concept of the present application, several modifications and improvements can be made, and these all belong to the protection scope of the present application. Therefore, the protection scope of the present application shall be subject to the appended claims.

**Claims**

1.  A method for power transmission line icing warning, comprising:

    obtaining a current line temperature and a current maximum sag of a target power transmission line;
    determining a predicted maximum sag of the target power transmission line at the current line temperature based on the current line temperature and a maximum sag-line temperature correspondence;
    determining whether there is ice on the target power transmission line based on the current maximum sag and the predicted maximum sag; and
    issuing an icing warning for the target power transmission line when it is determined that there is ice on the target power transmission line.

2.  The method according to claim 1, wherein the maximum sag-line temperature correspondence is determined by:

    obtaining historical monitoring data of the target power transmission line through a monitoring device installed on the target power transmission line, the historical monitoring data comprising historical line temperatures and historical maximum sags at different historical times;
    selecting, from the historical monitoring data, historical monitoring data of the target power transmission line in an ideal environment as target monitoring data, the ideal environment comprising at least an ice-free and wind-free environment; and
    constructing the maximum sag-line temperature correspondence for the target power transmission line based on the target monitoring data.

3.  The method according to claim 1, wherein determining whether there is ice on the target power transmission line based on the current maximum sag and the predicted maximum sag comprises:

    taking a difference between the current maximum sag and the predicted maximum sag as a sag difference; and
    if the sag difference is greater than a preset error threshold, determining that there is ice on the target power transmission line.

4.  The method according to claim 1, wherein issuing the icing warning for the target power transmission line comprises:

    obtaining characteristic data and a current specific load parameter of the target power transmission line;
    determining an icing thickness of the target power transmission line based on the characteristic data and the current specific load parameter; and
    issuing the icing warning for the target power transmission line based on the icing thickness.

5.  The method according to claim 4, wherein the characteristic data comprises static characteristic data and dynamic characteristic data, and obtaining the characteristic data and the current specific load parameter of the target power transmission line comprises:

    obtaining the dynamic characteristic data through a monitoring device installed on the target power transmission line;

determining the static characteristic data based on attribute information of the target power transmission line; and determining the current specific load parameter of the target power transmission line based on the static characteristic data, the dynamic characteristic data, the predicted maximum sag and the current maximum sag.

6. The method according to claim 5, wherein the static characteristic data comprises an outer diameter, a cross-sectional area, a mass parameter, a temperature expansion coefficient and an elasticity coefficient of the target power transmission line, the dynamic characteristic data comprises a horizontal span, a height difference angle, a wind deflection angle, a first temperature in an ideal environment and a second temperature in an abnormal environment of the target power transmission line, and the current specific load parameter comprises a self-weight specific load in the ideal environment and a comprehensive specific load in the abnormal environment; and
wherein the ideal environment comprises at least an ice-free and wind-free environment, and the abnormal environment comprises at least an ice-and-wind environment.

7. The method according to claim 6, wherein determining the current specific load parameter of the target power transmission line based on the static characteristic data, the dynamic characteristic data, the predicted maximum sag and the current maximum sag comprises:

   taking a product of the mass parameter and a gravitational acceleration as a first intermediate parameter;
   determining the self-weight specific load based on a ratio between the first intermediate parameter and the cross-sectional area; and
   determining the comprehensive specific load based on the self-weight specific load, the predicted maximum sag, the current maximum sag, the static characteristic data and the dynamic characteristic data.

8. The method according to claim 7, wherein determining the comprehensive specific load based on the self-weight specific load, the predicted maximum sag, the current maximum sag, the static characteristic data and the dynamic characteristic data comprises:

   taking a ratio of a product of the current maximum sag and the self-weight specific load to the predicted maximum sag as a second intermediate parameter;
   determining a third intermediate parameter based on the current maximum sag, the predicted maximum sag, the elasticity coefficient, the horizontal span and the height difference angle;
   determining a fourth intermediate parameter based on the temperature expansion coefficient, the current maximum sag, the first temperature, the second temperature, the height difference angle and the horizontal span; and
   taking a difference between the difference between the second intermediate parameter and the third intermediate parameter and the fourth intermediate parameter as the comprehensive specific load.

9. The method according to claim 6, wherein determining the icing thickness of the target power transmission line based on the characteristic data and the current specific load parameter, comprises:

   taking a difference between a product of a cosine value of the wind deflection angle and the comprehensive specific load and the self-weight specific load as a fifth intermediate parameter; and
   determining the icing thickness of the target power transmission line based on the cross-sectional area, the outer diameter and the fifth intermediate parameter.

10. The method according to claim 1, wherein issuing the icing warning for the target power transmission line when it is determined that there is ice on the target power transmission line comprises:

    issuing the icing warning for the target power transmission line to a control center corresponding to the target power transmission line,
    wherein the icing warning contains an on-site image of the target power transmission line.

11. The method according to claim 1, wherein the maximum sag-line temperature correspondence comprises a correspondence between the maximum sag, the line temperature and a humidity, and
wherein determining the predicted maximum sag of the target power transmission line at the current line temperature comprises:
determining the predicted maximum sag of the target power transmission line at the current line temperature based on the current line temperature, a current humidity, and the correspondence between the maximum sag, the line temperature and the humidity.

12. An apparatus for power transmission line icing warning, comprising:

a data obtaining module, configured to obtain a current line temperature and a current maximum sag of a target power transmission line;

a sag determination module, configured to determine a predicted maximum sag of the target power transmission line at the current line temperature based on the current line temperature and a maximum sag-line temperature correspondence;

an icing determination module, configured to determine whether there is ice on the target power transmission line based on the current maximum sag and the predicted maximum sag; and

an icing warning module, configured to issue an icing warning for the target power transmission line when it is determined that there is ice on the target power transmission line.

13. A computer device, comprising a processor and a memory storing a computer program therein, wherein the processor, when executing the computer program, is configured to perform a method for power transmission line icing warning according to any one of claims 1-11.

14. A computer-readable storage medium storing a computer program therein, wherein the computer program, when executed by a processor, causes the processor to perform a method for power transmission line icing warning according to any one of claims 1-11.

15. A computer program product comprising a computer program, wherein the computer program, when executed by a processor, causes the processor to perform a method for power transmission line icing warning according to any one of claims 1-11.

| Information processing device 101 |——| Monitoring device 102 |

FIG. 1

S201

Obtaining a current temperature and a current maximum sag of a target power transmission line

S202

Determining a predicted maximum sag of the target power transmission line at the current temperature based on the current temperature and a correspondence between a maximum sag and a temperature

S203

Determining whether there is ice on the target power transmission line based on the current maximum sag and the predicted maximum sag

S204

Issuing an icing early warning for the target power transmission line when it is determined that there is ice on the target power transmission line

FIG. 2

S301

Obtaining historical monitoring data of the target power transmission line through a monitoring device installed on the target power transmission line

S302

Selecting, from the historical monitoring data, historical monitoring data of the target power transmission line in an ideal environment as target monitoring data

S303

Constructing the correspondence between the maximum sag and the temperature for the target power transmission line based on the target monitoring data

FIG. 3

FIG. 4

S501

Taking a difference between the current maximum sag and the predicted maximum sag as a sag difference

S502

If the sag difference is greater than a preset error threshold, determining that there is ice on the target power transmission line

FIG. 5

S601

Obtaining characteristic data and a current specific load parameter of the target power transmission line

S602

Determining an icing thickness of the target power transmission line based on the characteristic data and the current specific load parameter

S603

Issuing the icing early warning for the target power transmission line based on the icing thickness

FIG. 6

Obtaining the dynamic characteristic data through a monitoring device installed on the target power transmission line

S701

Determining the static characteristic data based on attribute information of the target power transmission line

S702

Determining the current specific load parameter of the target power transmission line based on the static characteristic data, the dynamic characteristic data, the predicted maximum sag and the current maximum sag

S703

FIG. 7

Taking a product of the mass parameter and a gravitational acceleration as a first intermediate parameter

S801

Determining the self-weight specific load based on a ratio between the first intermediate parameter and the cross-sectional area

S802

Determining the comprehensive specific load based on the self-weight specific load, the predicted maximum sag, the current maximum sag, the static characteristic data and the dynamic characteristic data

S803

FIG. 8

Taking a ratio of a product of the current maximum sag and the self-weight specific load to the predicted maximum sag as a second intermediate parameter

S901

Determining a third intermediate parameter based on the current maximum sag, the predicted maximum sag, the elasticity coefficient, the horizontal span and the height difference angle

S902

Determining a fourth intermediate parameter based on the temperature expansion coefficient, the current maximum sag, the first temperature, the second temperature, the height difference angle and the horizontal span

S903

Taking a difference between the difference between the second intermediate parameter and the third intermediate parameter and the fourth intermediate parameter as the comprehensive specific load

S904

FIG. 9

Taking a difference between a product of a cosine value of the wind deflection angle and the comprehensive specific load and the self-weight specific load as a fifth intermediate parameter — S1001

Determining the icing thickness of the target power transmission line based on the cross-sectional area, the outer diameter and the fifth intermediate parameter — S1002

FIG. 10

Obtaining a current temperature and a current maximum sag of a target power transmission line — S1101

Determining a predicted maximum sag of the target power transmission line at the current temperature based on the current temperature and a correspondence between a maximum sag and a temperature — S1102

Taking a difference between the current maximum sag and the predicted maximum sag as a sag difference — S1103

Determining whether the sag difference is greater than a preset error threshold — S1104

No

Yes

Determining that there is no ice on the target power transmission line and continuing the monitoring

Determining that there is ice on the target power transmission line

Obtaining characteristic data of the target power transmission line — S1105

Taking a product of the mass parameter in the characteristic data and the gravitational acceleration as a first intermediate parameter — S1106

Determining a self-weight specific load based on a ratio between the first intermediate parameter and the cross-sectional area in the characteristic data — S1107

Determining a comprehensive specific load based on the self-weight specific load, the predicted maximum sag, the current maximum sag and the characteristic data — S1108

Taking a difference between a product of the cosine value of the wind-deflection angle in the characteristic data and the comprehensive specific load and the self-weight specific load as a fifth intermediate parameter — S1109

Determining an icing thickness of the target power transmission line based on the cross-sectional area, the outer diameter in the characteristic data and the fifth intermediate parameter — S1110

Issuing an icing early warning for the target power transmission line based on the icing thickness — S1111

FIG. 11

Apparatus for power transmission
line icing early warning

10

Data obtaining module

20

Sag determination module

30

Icing determination module

40

Icing early warning module

FIG. 12

Memory

Operation system

Computer program

Database

Non-transitory
storage medium

Processor

Internal
Memory

System bus

I/O interface

Communication
interface

Computer device

FIG. 13

EUROPEAN SEARCH REPORT

Application Number

EP 25 18 2986

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | HUANG GUIZAO ET AL: "Risk assessment models of power transmission lines undergoing heavy ice at mountain zones based on numerical model and machine learning", JOURNAL OF CLEANER PRODUCTION, ELSEVIER, AMSTERDAM, NL, vol. 415, 8 June 2023 (2023-06-08), XP087347262, ISSN: 0959-6526, DOI: 10.1016/J.JCLEPRO.2023.137623 [retrieved on 2023-06-08] * page 12, last paragraph * * page 10, right-hand column * * page 3, right-hand column * ----- | 1-15 | INV. H02J13/00 H02J3/00 H02G7/16 H02G1/02 H02G7/00 |
| A | CN 102 054 328 A (YUNNAN PROVINCIAL ELECTRIC POWER TEST & RES INST GROUP CO LTD ET AL.) 11 May 2011 (2011-05-11) * the whole document * ----- | 1-15 | |
| A | NIKOLOV NIKOLA ET AL: "Comparison of the conductors' mechanical mode calculations using different mathematical models", 2017 15TH INTERNATIONAL CONFERENCE ON ELECTRICAL MACHINES, DRIVES AND POWER SYSTEMS (ELMA), IEEE, 1 June 2017 (2017-06-01), pages 339-347, XP033107526, DOI: 10.1109/ELMA.2017.7955460 ISBN: 978-1-5090-6690-2 [retrieved on 2017-06-22] * abstract * * page 339, left-hand column * ----- | 1-15 | TECHNICAL FIELDS SEARCHED (IPC) H02J H02G |

The present search report has been drawn up for all claims

| Place of search | Date of completion of the search | Examiner |
|---|---|---|
| Munich | 19 November 2025 | Zettler, Karl-Rudolf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 18 2986

This annex lists the patent family members relating to the patent documents cited in the above-mentioned European search report.
The members are as contained in the European Patent Office EDP file on
The European Patent Office is in no way liable for these particulars which are merely given for the purpose of information.

19-11-2025

| Patent document cited in search report | Publication date | Patent family member(s) | Publication date |
|---|---|---|---|
| CN 102054328 A | 11-05-2011 | NONE | |

EPO FORM P0459

For more details about this annex : see Official Journal of the European Patent Office, No. 12/82

EP 4 704 301 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202411193155